# EUROPÄISCHE PATENTSCHRIFT

(11) **EP 1 817 946 B1**
(45) Veröffentlichungstag und Bekanntmachung des Hinweises auf die Patenterteilung: **31.12.2008**
(21) Anmeldenummer: 05814631.7
(22) Anmeldetag: 18.11.2005
(51) Int. Cl.: H05K 3/12

(54) **VERFAHREN UND VORRICHTUNG ZUR ERZEUGUNG VON STRUKTUREN AUS FUNKTIONSMATERIALIEN**
METHOD AND DEVICE FOR PRODUCING STRUCTURES FROM FUNCTIONAL MATERIALS
PROCEDE ET DISPOSITIF POUR PRODUIRE DES STRUCTURES A PARTIR DE MATERIAUX FONCTIONNELS

(30) Priorität: 02.12.2004 DE 102004058209
(43) Veröffentlichungstag der Anmeldung: 15.08.2007
(73) Patentinhaber: Printed Systems GmbH, 01925 Chemnitz (DE)
(72) Erfinder: FISCHER, Thomas, 09117 Chemnitz (DE)
(74) Vertreter: Tetzner, Michael
(86) Internationale Anmeldenummer: PCT/EP2005/012390
(87) Internationale Veröffentlichungsnummer: WO 2006/058622

(56) Entgegenhaltungen:
- EP-A- 1 060 875
- EP-B- 0 958 915
- JP-A- 2003 209 339
- US-A- 5 654 378

## Beschreibung

Die Erfindung betrifft ein Verfahren und eine Vorrichtung zur Erzeugung von Strukturen aus Funktionsmaterialien, insbesondere elektrischen Funktionsmaterialien, wobei in einem ersten Verfahrensschritt das Substrat derart vorbehandelt wird, dass wenigstens ein erster und ein zweiter Bereich mit unterschiedlichen Oberflächenspannungen gebildet werden, wobei der erste Bereich in der Form der zu erzeugenden Struktur ausgebildet ist, und in einem zweiten Verfahrenschritt das Funktionsmaterial auf das Substrat aufgebracht wird, wobei das Funktionsmaterial so ausgebildet ist, dass es sich lediglich im ersten Bereich anlagert und so die gewünschte Struktur aus Funktionsmaterial gebildet wird.

Aus der DE-A-102 29 118 ist ein Verfahren zur Herstellung von Leiterstrecken aus einem elektrisch leitfähigen organischen Material bekannt. Dazu werden auf einer Substratoberfläche durch Aufdrucken einer Matrizenverbindung Abschnitte definiert, so dass eine Substratoberfläche mit hydrophilen und hydrophoben Abschnitten erhalten wird. Auf die strukturierte Substratoberfläche wird eine Lösung des elektrisch leitfähigen organischen Polymers gegeben, wobei entweder nur die hydrophilen Abschnitte oder nur die hydrophoben Abschnitte von der Lösung des organischen Polymers benetzt werden.

Ein ähnliches Verfahren ist aus der US-A-20020083858 bekannt.

Diese bekannten Verfahren haben jedoch den Nachteil, dass zur Strukturierung zunächst ein Material aufgetragen werden muss. Wenngleich das hierfür verwendete Druckverfahren Vorteile bringt, entstehen hierdurch auch Nachteile. So muss beispielsweise das zu erst gedruckte Strukturierungsmaterial wieder entfernt werden oder verbleibt, ohne nach dem Herstellungsprozess eine Funktion zu haben, auf dem Substrat. Weiterhin kann sich die Materialabstimmung zwischen dem Substrat, dem erstgedruckten Strukturierungsmaterial und dem später aufgetragenen Funktionsmaterial als schwierig erweisen.

Der Erfindung liegt daher die Aufgabe zugrunde, das Verfahren und die Vorrichtung zur Erzeugung von Strukturen aus Funktionsmaterialien weiterzuverbessern, wobei insbesondere kein zusätzliches Strukturierungsmaterial aufgebracht werden muss.

Erfindungsgemäß wird diese Aufgabe durch die Merkmale der Ansprüche 1 bzw. 11 gelöst.

Beim erfindungsgemäßen Verfahren zur Erzeugung von Strukturen aus Funktionsmaterialien, insbesondere elektrischen Funktionsmaterialien, wird in einem ersten Verfahrensschritt das Substrat derart vorbehandelt, dass wenigstens ein erster und ein zweiter Bereich mit unterschiedlichen Oberflächenspannungen gebildet werden, wobei der erste Bereich in der Form der zu erzeugenden Struktur ausgebildet ist. Dabei wird zunächst eine homogene, gegenüber den normalen Zustand des Substrats höhere Oberflächenspannung des Substrats erzeugt, um dann das Substrat im ersten oder zweiten Bereich in der oberen Oberflächenspannung auf einen niedrigeren Wert herabzusetzen. In einem zweiten Verfahrensschritt wird dann das Funktionsmaterial auf das Substrat aufgebracht, wobei das Funktionsmaterial so ausgebildet ist, dass es sich lediglich im ersten Bereich anlagert und so die gewünschte Struktur aus Funktionsmaterial gebildet wird.

Die Vorrichtung zur Durchführung des obigen Verfahrens besteht im wesentlichen aus einer Einrichtung zur Erzeugung einer homogenen, gegenüber dem normalen Zustand des Substrats höheren Oberflächenspannung des Substrats, einer Einrichtung um das Substrat im ersten oder zweiten Bereich in der Oberflächenspannung auf einer niedrigeren Wert herabzusetzen sowie einer Einrichtung zum Aufbringen des Funktionsmaterials auf das Substrat.

Weitere Ausgestaltungen der Erfindung sind Gegenstand der Unteransprüche.

Gemäß einer bevorzugten Ausgestaltung der Erfindung erfolgt die Erzeugung der homogenen Oberflächenspannung durch eine Coronabehandlung. Im Rahmen der Erfindung ist diesbezüglich aber auch eine chemische, eine mechanische und/oder eine tribologische Behandlung denkbar.

Gemäß einem Ausführungsbeispiel der Erfindung erfolgt die Herabsetzung der Oberflächenspannung durch Kontakt mit einer Kontakstruktur.

Das Aufbringen des Funktionsmaterials im zweiten Verfahrensschritt kann beispielsweise durch ein Walzverfahren, ein Sprühverfahren, ein Tauchverfahren oder ein Vorhangbeschichtungsverfahren erfolgen.

Weitere Vorteile und Ausgestaltungen der Erfindung werden im folgenden anhand der Beschreibung eines Ausführungsbeispieles und der Zeichnung näher erläutert.

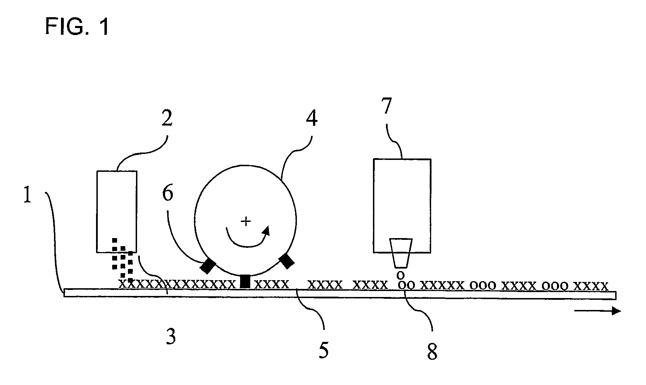

In der Zeichnung zeigen
- Fig. 1: eine schematische Darstellung der Vorrichtung zur Erzeugung von Strukturen aus Funktionsmaterialien und
- Fig.2a-2c: schematische Darstellung der Substratsoberfläche in den verschiedenen Verfahrensschritten.

Beim erfindungsgemäßen Verfahren wird zur Strukturierung der Oberflächenpolarität kein Material aufgedruckt oder auf anderen Wege aufgetragen. Es wird vielmehr ein geeignetes Substrat 1, beispielsweise eine Kunststofffolie, insbesondere eine PET-Folie verwendet, welche verschiedene Oberflächenzustände annehmen kann.

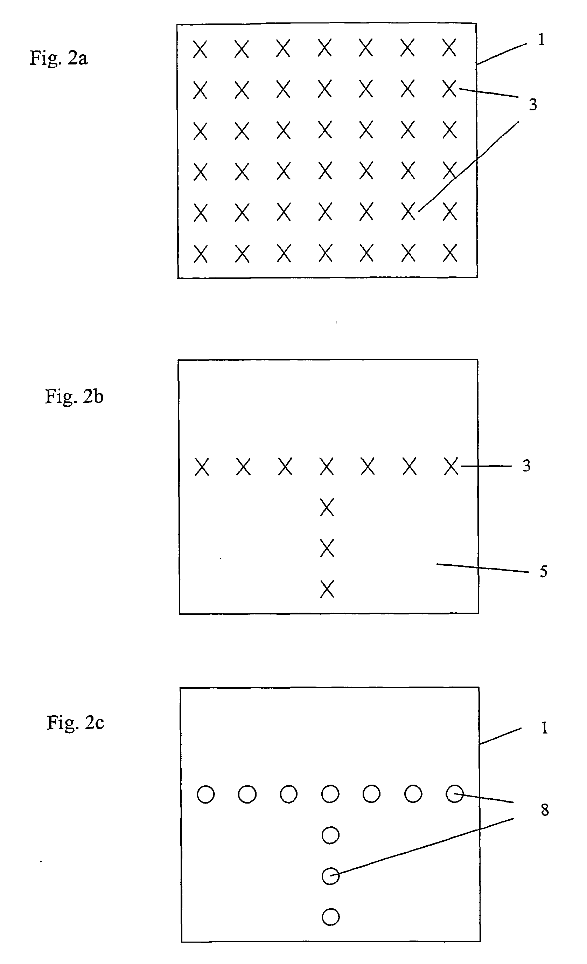

Das Substrat 1 passiert somit zunächst eine Einrichtung 2 zur Erzeugung einer homogenen, gegenüber dem normalen Zustand des Substrats höheren Oberflächenspannung. Eine derartige Oberflächenaktivierung kann beispielsweise durch eine Einrichtung zur Coronabehandlung gebildet werden, bei der die Oberfläche des Substrats 1 in einem Hochspannungsfeld mit Elektronen und ggf. Ionen bestrahlt wird. Die behandelte Oberfläche des Substrats weist dann eine homogene, gegenüber dem normalen Zustand des Substrats höhere Oberflächenspannung auf (siehe Fig. 2a).

Im nächsten Schritt wird mit Hilfe einer Einrichtung 4 die Oberflächenspannung in bestimmten Bereichen herabgesetzt, so dass wenigstens ein erster Bereich 3 und zweiter Bereich 5 mit unterschiedlichen Oberflächenspannungen gebildet werden, wobei der erste Bereich in der Form der zu erzeugenden Struktur ausgebildet ist.

Das Herabsetzen der Oberflächenspannung, hier in den Bereichen 5, kann beispielsweise dadurch erreicht werden, dass das aktivierte Substrat in den Bereichen 5 mit einer Kontaktstruktur der Einrichtung 4 in Kontakt gebracht wird, wobei sich die vorherige Aktivierung der Oberfläche an dieser Stelle wieder neutralisiert und sich wieder die ursprüngliche, niedrigere Oberflächenspannung einstellt.

Die Einrichtung 4 zur Herabsetzung der Oberflächenspannung kann beispielsweise durch eine mit der Oberfläche des Substrats in Kontakt kommende Walze oder Platte gebildet wird, die erhabene Kontaktstrukturen 6 aufweist, wobei lediglich die erhabenen Kontaktstrukturen der Walze/Platte mit der Oberfläche des Substrats in Kontakt. Zweckmäßigerweise sind die bestehende Kontaktstrukturen aus einem Material, welches die Deaktivierung unterstützt. Als sehr günstig haben sich in diesem Zusammenhang beispielsweise handelsübliche Flexodruckplatten oder Trockenoffsetplatten erwiesen. Es sind jedoch auch andere Materialien denkbar.

Durch eine entsprechend feine Ausbildung der Kontaktstruktur 6 kann dann eine entsprechende Struktur in der aktivierten Substratoberfläche erzeugt werden, wobei einzelne Bereiche 5 des Substrats eine reduzierte Oberflächenspannung erhalten als die Bereiche 3, die nicht in Kontakt mit den Kontaktstrukturen 6 kommen und auf dem zuvor eingestellten hohen Niveau der Oberflächenspannung verbleiben.

Im letzen Verfahrensschritt wird das eigentliche Funktionsmaterial 8, insbesondere ein elektrisches Funktionsmaterial, mittels einer Einrichtung 7 auf das Substrat aufgebracht, wobei das Funktionsmaterial so ausgebildet ist, das es sich lediglich im ersten Bereich 3 anlagert und so die gewünschte Struktur aus Funktionsmaterial gebildet wird. Je nach Art des Funktionsmaterials wird sich dieses in den noch aktivierten oder in den durch die Kontaktstrukturen deaktivierten Bereichen anlagern. Im dargestellten Fall wurde ein Funktionsmaterial gewählt, welches sich in den aktivierten Bereichen anlagert. Die gewünschte Struktur aus Funktionsmaterial, beispielsweise in Form von Leiterbahnen, ist in Fig. 2c dargestellt.

Das Funktionsmaterial wird beispielsweise aus einem elektrisch leitfähigen organischen Polymer gebildet, welches im flüssig Zustand aufgebracht wird, wobei allerdings die Viskosität ausreichend niedrig und die flüssige Phase vor einem Trocknungsprozess ausreichend lange gewährleistet sein muss, so dass sich die Flüssigkeit entsprechend der gewünschten Struktur verteilen kann.

Als Auftragsverfahren für das Funktionsmaterial 8 kommen alle Verfahren in Betracht, die einen ausreichend gleichmäßigen Materialauftrag ermöglichen. Hierfür eignet sich insbesondere ein Sprühverfahren, bei dem die Substratoberfläche mit dem Funktionsmaterial besprüht wird, wobei sich das Funktionsmaterial aufgrund der unterschiedlichen Oberflächenspannungen nur in den Bereichen mit passender Oberflächenspannung anlagert.

Für diesen Verfahrensschritt könnte das Funktionsmaterial aber auch durch ein Tauchverfahren aufgebracht werden, indem das Substrat in das flüssige Funktionsmaterial eingetaucht wird.

Eine weitere Möglichkeit stellt ein Vorhangbeschichtungsverfahren dar, bei dem die Substratoberfläche an ein oder mehreren Flüssigkeitsstrahlen des Funktionsmaterials vorbeigeführt wird.

## Patentansprüche

1. Verfahren zur Erzeugung von Strukturen aus Funktionsmaterialen, insbesondere elektrischen Funktionsmaterialien, wobei in einem ersten Verfahrenschritt das Substrat (1) derart vorbehandelt wird, dass wenigstens ein erster und ein zweiter Bereich (3, 5) mit unterschiedlichen Oberflächenspannungen gebildet werden, wobei der erste Bereich in der Form der zu erzeugenden Struktur ausgebildet ist, und in einem zweiten Verfahrenschritt das Funktionsmaterial auf das Substrat aufgebracht wird, wobei das Funlctionsmaterial (8) so ausgebildet ist, dass es sich lediglich im ersten Bereich anlagert und so die gewünschte Struktur aus Funh-tionsmaterial gebildet wird,
**dadurch gekennzeichnet, dass** im ersten Verfahrenschritt zunächst eine homogene, gegenüber dem normalen Zustand des Substrats (1) höhere Oberflächenspannung des Substrats erzeugt wird und dann das Substrat im ersten oder zweiten Bereich in der Oberflächenspannung auf einen niedrigeren Wert herabgesetzt wird.

2. Verfahren nach Anspruch 1, **dadurch gekennzeichnet, dass** die Erzeugung der homogenen Oberflächenspannung durch eine Coronabehandlung erfolgt.

3. Verfahren nach Anspruch 1, **dadurch gekennzeichnet, dass** die Erzeugung der homogenen Oberflächenspannung durch eine chemische Behandlung erfolgt.

4. Verfahren nach Anspruch 1, **dadurch gekennzeichnet, dass** die Erzeugung der homogenen Oberflächenspannung durch eine mechanische und/oder tribologische Behandlung erfolgt.

5. Verfahren nach Anspruch 1, **dadurch gekennzeichnet, dass** die Erzeugung der homogenen Oberflächenspannung durch eine Kombination der Ansprüche 2 bis 4 erfolgt.

6. Verfahren nach Anspruch 1, **dadurch gekennzeichnet, dass** die Herabsetzung der Oberflächenspannung durch Kontakt mit einer Kontaktstruktur (6) erfolgt.

7. Verfahren nach Anspruch 1, **dadurch gekennzeichnet, dass** das Funktionsmaterial im zweiten Verfahrenschritt in einem Walzverfahren aufgebracht wird, in dem eine mit Funktionsmaterial bedeckte Walze auf der Substratoberfläche abgerollt wird, wobei sich das Funktionsmaterial aufgrund der unterschiedlichen Oberflächenspannungen nur in dem Bereich mit passender Oberflächenspannung anlagert.

8. Verfahren nach Anspruch 1, **dadurch gekennzeichnet, dass** das Funktionsmaterial im zweiten Verfahrenschritt in einem Sprühverfahren aufgebracht wird, in dem die Substratoberfläche mit dem Funktionsmaterial besprüht wird, wobei sich das Funktionsmaterial aufgrund der unterschiedlichen Oberflächenspannungen nur in dem Bereich mit passender Oberflächenspannung anlagert.

9. Verfahren nach Anspruch 1, **dadurch gekennzeichnet, dass** das Funktionsmaterial im zweiten Verfahrenschritt in einem Tauchverfahren aufgebracht wird, indem das Substrat in das flüssige Funktionsmaterial eingetaucht wird, wobei sich das Funktionsmaterial aufgrund der unterschiedlichen Oberflächenspannungen nur in dem Bereich mit passender Oberflächenspannung anlagert.

10. Verfahren nach Anspruch 1, **dadurch gekennzeichnet, dass** das Funktionsmaterial im zweiten Verfahrenschritt in einem Vorhangbeschichtungsverfahren aufgebracht wird, indem die Substratoberfläche an ein oder mehreren Flüssigkeitsstrahlen des Funktionsmaterials vorbeigeführt wird, wobei sich das Funktionsmaterial aufgrund der unterschiedlichen Oberflächenspannungen nur in dem Bereich mit passender Oberflächenspannung anlagert.

11. Vorrichtung zur Durchführung des Verfahrens nach einem oder mehreren der vorhergehenden Ansprüche, enthaltend eine Einrichtung (2) zur Erzeugung einer homogenen, gegenüber dem normalen Zustand des Substrats höheren Oberflächenspannung des Substrats, eine Einrichtung (4), um das Substrat im ersten oder zweiten Bereich in der Oberflächenspannung auf einen niedrigeren Wert herabzusetzen sowie eine Einrichtung (7) zum Aufbringen des Funktionsmaterials auf das Substrat.

12. Vorrichtung nach Anspruch 11, **dadurch gekennzeichnet, dass** die Einrichtung (2) zur Erzeugung einer homogenen Oberflächenspannung durch eine Einrichtung zur Coronabehandlung gebildet wird.

13. Vorrichtung nach Anspruch 11, **dadurch gekennzeichnet, dass** die Einrichtung (4) zur Herabsetzung der Oberflächenspannung durch eine mit der Oberfläche des Substrats in Kontakt kommende Walze oder Platte gebildet wird, die erhabene Kontaktstrukturen (6) aufweist, wobei lediglich die erhabenen Kontaktstrukturen der Walze/Platte mit der Oberfläche des Substrats in Kontakt kommen.

## Claims

1. Method of producing structures from functional materials, in particular electrical functional materials, in which in a first method step the substrate (1) is pretreated in such a way that at least a first and a second region (3, 5) are formed with different surface tensions, the first region being configured in the shape of the structure to be produced, and in a second method step the functional material is applied to the substrate, the functional material (8) being configured so that it is deposited only in the first region and thus the desired structure is formed from functional material, **characterised in that** in a first method step first of all a homogeneous surface tension of the substrate is produced which is higher relative to the normal state of the substrate and then the surface tension of the substrate is reduced to a lower value in the first or second region.

2. Method as claimed in Claim 1, **characterised in that** the production of the homogeneous surface tension takes place by a corona treatment.

3. Method as claimed in Claim 1, **characterised in that** the production of the homogeneous surface tension takes place by a chemical treatment.

4. Method as claimed in Claim 1, **characterised in that** the production of the homogeneous surface tension takes place by a mechanical and/or tribological treatment.

5. Method as claimed in Claim 1, **characterised in that** the production of the homogeneous surface tension takes place by a combination of Claims 2 to 4.

6. Method as claimed in Claim 1, **characterised in that** the reduction of the surface tension takes place by contact with a contact structure (6).

7. Method as claimed in Claim 1, **characterised in that** in the second method step the functional material is applied in a rolling process in which a roller covered with functional material is rolled on the substrate surface, the functional material being deposited only in the region with suitable surface tension because of the different surface tensions.

8. Method as claimed in Claim 1, **characterised in that** in the second method step the functional material is applied in a spraying process in which the substrate surface is sprayed with the functional material, the functional material being deposited only in the region with suitable surface tension because of the different surface tensions.

9. Method as claimed in Claim 1, **characterised in that** in the second method step the functional material is applied in a dipping process, **in that** the substrate is dipped into the fluid functional material, the functional material being deposited only in the region with suitable surface tension because of the different surface tensions.

10. Method as claimed in Claim 1, **characterised in that** in the second method step the functional material is applied in a curtain coating process, **in that** the substrate is guided past one or several fluid jets of the functional material, the functional material being deposited only in the region with suitable surface tension because of the different surface tensions.

11. Apparatus for carrying out the method as claimed in one or more of the preceding claims, comprising a means (2) for producing a homogeneous surface tension of the substrate which is higher relative to the normal state of the substrate, a means (4) for reducing the surface tension of the substrate in the first or second region to a lower value as well as a means (7) for application of the functional material to the substrate.

12. Apparatus as claimed in Claim 11, **characterised in that** the means (2) for producing a homogeneous surface tension is formed by a means for corona treatment.

13. Apparatus as claimed in Claim 11, **characterised in that** the means (4) for reducing the surface tension is formed by a roller or plate which comes into contact with the surface of the substrate and has raised contact structures, only the raised contact structures of the roller/plate coming into contact with the surface of the substrate.

## Revendications

1. Procédé pour la fabrication de structures en matériaux fonctionnels, en particulier en matériaux fonctionnels électriques, le substrat (1) étant prétraité au cours d'une première étape du procédé, de sorte à former au moins une première et une deuxième zones (3, 5) avec des tensions superficielles différentes, la première zone étant réalisée sous la forme de la structure à fabriquer, et le matériau fonctionnel étant appliqué sur le substrat au cours d'une deuxième étape du processus, ledit matériau fonctionnel (8) étant conçu de sorte qu'il s'incruste seulement dans la première zone et que la structure désirée soit ainsi réalisée à partir du matériau fonctionnel, **caractérisé en ce que**, dans une première étape du processus, une tension superficielle de substrat homogène, plus élevée que celle du substrat (1) à l'état normal est d'abord générée, et que la tension superficielle du substrat est ensuite amenée à une valeur plus faible, dans une première ou une deuxième zone.

2. Procédé selon la revendication 1, **caractérisé en ce que** la tension superficielle homogène est générée par traitement corona.

3. Procédé selon la revendication 1, **caractérisé en ce que** la tension superficielle homogène est générée par un traitement chimique.

4. Procédé selon la revendication 1, **caractérisé en ce que** la tension superficielle homogène est générée par un traitement mécanique et / ou tribologique.

5. Procédé selon la revendication 1, **caractérisé en ce que** la tension superficielle homogène est générée par une combinaison des revendications 2 à 4.

6. Procédé selon la revendication 1, **caractérisé en ce que** la réduction de la tension superficielle est effectuée par contact avec une structure de contact (6).

7. Procédé selon la revendication 1, **caractérisée en ce que** le matériau fonctionnel, dans la deuxième étape du processus, est appliqué selon un procédé de laminage, dans lequel un rouleau revêtu de matériau fonctionnel est roulé sur la surface du substrat, le matériau fonctionnel s'incrustant seulement dans la zone à tension superficielle appropriée, en raison des différentes tensions superficielles.

8. Procédé selon la revendication 1, **caractérisé en ce que** le matériau fonctionnel, dans la deuxième étape du processus, est appliqué selon un procédé de pulvérisation, dans lequel le matériau fonctionnel est pulvérisé sur la surface du substrat, le matériau fonctionnel s'incrustant seulement dans la zone à tension superficielle appropriée, en raison des différentes tensions superficielles.

9. Procédé selon la revendication 1, **caractérisée en ce que** le matériau fonctionnel, dans la deuxième étape du processus, est appliqué selon un procédé d'immersion, dans lequel le substrat est plongé dans le matériau fonctionnel, le matériau fonctionnel s'incrustant seulement dans la zone à tension superficielle appropriée, en raison des différentes tensions superficielles.

10. Procédé selon la revendication 1, **caractérisée en ce que** le matériau fonctionnel, dans la deuxième étape du processus, est appliqué selon un procédé de revêtement en rideau, dans lequel la surface du substrat passe devant un ou de plusieurs jets de matériau fonctionnel liquide, le matériau fonctionnel s'incrustant seulement dans la zone à tension superficielle appropriée, en raison des différentes tensions superficielles.

11. Dispositif pour l'exécution du procédé selon l'une ou plusieurs des revendications précédentes, qui comprend un dispositif (2) pour la réalisation d'une tension superficielle de substrat homogène, plus élevée que celle du substrat à l'état normal, un dispositif (4) pour la réduction de la tension superficielle du substrat à une valeur plus faible, dans la première ou la deuxième zone, ainsi qu'un dispositif (7) pour l'application du matériau fonctionnel sur le substrat.

12. Dispositif selon la revendication 11, **caractérisé en ce que** le dispositif (2) pour la réalisation d'une tension superficielle homogène est formé par un dispositif de traitement corona.

13. Dispositif selon la revendication 11, **caractérisé en ce que** le dispositif (4) pour la réduction de la tension superficielle est formé par un rouleau ou une plaque, qui entre en contact avec la surface du substrat et qui présente des structures de contact (6) en relief, seules les structures de contact en relief du rouleau / de la plaque entrant en contact avec la surface du substrat.
